# EUROPEAN PATENT SPECIFICATION

(11) **EP 0 403 580 B1**
(45) Date of publication and mention of the grant of the patent: **08.01.1997**
(21) Application number: 89906609.6
(22) Date of filing: 08.05.1989
(51) Int. Cl.: G03C 1/54, G03F 7/26

(54) **LIGHT-SENSITIVE NOVOLAC RESINS**
LICHTEMPFINDLICHE NOVOLAK-HARZE
RESINES NOVOLAQUES SENSIBLES A LA LUMIERE

(30) Priority: 10.08.1988 US 230760
(43) Date of publication of application: 27.12.1990
(73) Proprietor: HOECHST CELANESE CORPORATION, Somerville, N.J. 08876 (US)
(72) Inventor: SHALOM, Eitan, 44 100 Kefar Sava (IL)
(74) Representative: Pendlebury, Anthony
(86) International application number: US8901904
(87) International publication number: WO9001726

(56) References cited:
- US-A- 4 141 733
- US-A- 4 306 011
- US-A- 4 308 368
- US-A- 4 529 682
- US-A- 4 555 469
- Solid State Technology, issued June 1984, (PAMPALONE, T.R.), Novolac Resins used in Positive Resist Systems, pages 115-120. See page 116, First column, Last Four Lines.

## Description

### 1. Field of the Invention.

This invention relates to light-sensitive resins and photoresist compositions containing the same and is more particularly concerned with light-sensitive novolac resins and positive-acting photoresist compositions containing said resins as the photosensitizer.

### 2. Description of the Prior Art.

Photoresist compositions which give rise to positive resist images are well-known in the art. These compositions generally comprise an alkali-soluble polymer such as a novolac resin and a photoactive component containing diazo and keto groups on adjacent positions in a benzenoid structure. The latter is generally an ester of a 2-diazo-1,2-naphthoquinone-4- or 5-sulfonic acid and a polyhydroxy compound such as trihydroxybenzophenone. Exposure of these photoresist compositions imagewise to actinic light serves to convert the diazo-keto configurations of the sensitizer to a carboxylic acid-containing moiety. Hence, those portions of the photoresist which have been exposed to the actinic radiation are rendered soluble in alkali. The desired photoresist image is developed using alkaline developers.

The production of microelectronic circuitry has now reached a stage in which the width between lines in the circuitry is 1 micrometer or less. This requires the use of photoresist compositions capable of giving high resolution, high contrast and near vertical sidewalls. The photoresist composition is generally applied to the substrate as a thin layer which, after removal of solvent, has a thickness of the order of 1 to 2 micrometers. Hence, in the fabrication of the above fine resolution circuitry, the aspect ratio (ratio of film thickness to line width in the image) is more than one. In the imagewise radiation of a photoresist layer of about 1 micron thickness, some scattering of the light can occur resulting in loss of sharpness of the edges, loss of definition and the formation of sloping or undercut sidewalls of the developed image. Further, in development of the image using alkaline developers, some loss of resist from the unexposed portions of the resist can occur since the binder generally used in the resist, namely a novolac resin, has some limited solubility in the developer. This contributes to loss of depth of the image and can affect the sharpness of the image.

Guild U.S. Patent 4,141,733 describes the use of a particular developer, namely methyltriethanol ammonium hydroxide, as a means of overcoming the problem of lack of high definition of the image. The use of this developer is said to give improved development time latitude, development temperature latitude, exposure latitude, prebake latitude, resist contrast, depletion rate, and retention of image layer thickness. In the preferred embodiments of the process described by Guild, the photoresist system employed is a mixture of a resinous binder (which can be a novolac resin) and a light-sensitive polymeric compound which is the reaction product of a 2-diazo-1,2-naphthoquinone-5-sulfonyl halide and a novolac resin having a molecular weight of 350 - 40,000. The molar ratio of diazo compound to resin can lie within a very broad range, namely 99:1 to 1:99 but is preferably in the range of 1:25 to 1:5. The weight ratio of this light-sensitive polymer to the non-light sensitive resinous binder in the photoresist composition is in the range of about 1:1 to about 99:1, i.e. the light-sensitive polymer is always present in the mixture in an amount of 50 percent by weight or higher.

US-A-4308368 discloses a high sensitivity novolac resin which contains alkyl phenol with a C3 to C12 alkyl substituent and at least one phenol or methylphenol, i.e. para, meta or ortho cresol. US-A-4555469 discloses that diazoquinone sulfonyl halide preferentially reacts with the low molecular weight constituent but also with cresol novolac, i.e. meta, ortho or para cresol novolac.

It has now been found that the difficulties described above in regard to the formation of satisfactory photoresist images with sub-micron resolution can be overcome without the need to use special developers such as that described by Guild, supra. Thus, it has been found that, by employing a light-sensitive polymeric resin having a particular and carefully selected composition in combination with a non-light-sensitive novolac resin binder in a particular weight ratio, it is possible to formulate a photoresist composition which can be developed using conventional alkaline developers and which gives rise to resist images exhibiting high contrast and sub-micron resolution with substantially vertical sidewalls.

### SUMMARY OF THE INVENTION

It is an object of the invention to provide a photoresist composition which can be employed to give resist images exhibiting high contrast and sub-micron resolutions with substantially vertical sidewalls.

It is a further object of the invention to provide a photoresist composition which comprises a mixture of a light-sensitive polymeric resin and a non-light-sensitive polymeric binder and which can be used to prepare resist images capable of development by conventional alkaline developers, said images exhibiting excellent contrast and sub-micron resulutions with substantially vertical sidewalls.

The present invention provides a positive photoresist composition which comprises, in admixture:
(a) a light-sensitive novolac resin; and
(b) a non-light-sensitive novolac resin;
   said component (a) comprising the product of reaction of a 2-diazo-1,2-naphthoquinone sulfonyl halide and a novolac obtained by the reaction of para cresol and formaldehyde and having an average molecular weight in the range of about 500 to about 1500 using a ratio of moles of halide per hydroxyl group in said resin in the range of about 1:1 to about 1:5;
   the ratio by weight of component (a) to component (b) being within the range of about 1:1 to about 1:10.

The invention also provides a method of making a positive resist image on a substrate which method comprises coating the substrate with a layer of the above composition, exposing the layer imagewise to ultraviolet radiation and developing the image using an alkaline developer.

### DETAILED DESCRIPTION OF THE INVENTION

The main components of the photoresist compositions of the invention are (a) a light-sensitive novolac resin and (b) a non-light-sensitive novolac resin. As set forth above, the light-sensitive novolac resin (a) comprises the product of reaction of a 2-diazo-1,2-naphthoquinone sulfonyl halide (I) and a novolac of a particular composition. A number of parameters are important in the formulation of this product. Thus, the novolac is one in which the phenol component is a p-cresol.

The novolac resin is prepared by acid-catalysed condensation of the said phenol component with formaldehyde using procedures conventionally employed in the art; see, for example, Chemistry and Application of Phenolic Resins, Knop et al., Chapter 4, Springer Verlag, New York, 1979. However, the novolac resin so prepared for use in the present invention has a molecular weight in the range of about 500 to about 1500 and, preferably, in the range of about 700 to about 1000. Novolac resins having average molecular weights in this range are prepared advantageously by employing a large excess over the stoichiometric amount of the phenol and using as the catalyst an organic acid such as formic, oxalic, propionic, succinic, maleic and like acids. The formaldehyde is employed as an aqueous solution and not in the form of paraformaldehyde or trioxane.

In addition to the molecular weight and the nature of the phenol component in the novolac resin used to prepare the above component (a), the reactant proportions employed in the reaction of the diazo sulfonyl halide (I) and the novolac resin play an important role in the properties of the component (a). Thus, it has been found that the ratio of moles of the sulfonyl halide (I) per hydroxyl group in the novolac resin advantageously should lie in the range of about 1:1 to about 1:5 and preferably should be of the order of about 1:2 to 1:4. Thus, the component (a) has a much higher proportion of diazo naphthoquinone sulfonyl substituents on the novolac resin than in the case of the preferred light-sensitive novolac resins described in the aforesaid U.S. Patent 4,141,733. The preferred molar ratio of diazo sulfonyl halide to novolac resin described in the latter patent is in the range of 1:25 to 1:5. The consequences of this difference will become apparent from the description below.

The reaction between the sulfonyl halide (I) and the novolac resin to prepare component (a) is carried out, using reactant proportions in the above described range, in the presence of a base under conditions conventional in the art for acylation or alkylation of a phenol. The reaction is conducted in the presence of a solvent which is advantageously an inert organic solvent, i.e. an organic solvent which does not itself react with any of the reactants or interfere in any manner with the desired course of the reaction. Illustrative of solvents are water-miscible solvents such as dioxane, tetrahydrofuran, acetone, acetonitrile, mixtures of the above, and the like.

The base employed in the reaction can be any of those conventionally employed in such reactions. Illustrative of bases are inorganic bases such as alkali metal and alkaline earth metal hydroxides and carbonates typically employed as an aqueous solution; alkali metal alkoxides such as sodium methoxide, sodium ethoxide and the like typically employed as an alcoholic solution; tertiary organic amines such as pyridine, N-methylpyrrolidine, N-methylpiperidine, triethylamine, N,N-dimethylethanolamine, N,N-diethylethanolamine and the like. The base is generally employed in at least a stoichiometric amount, i.e., 1 mole per mole of sulfonyl halide (I) but higher proportions can be employed if desired.

The reaction can be conducted at ambient temperatures, i.e. of the order of about 20-25°C., but higher or lower temperatures, i.e. from about 10°C up to the boiling point of the solvent employed, can be used depending upon the rate of reaction desired.

As the reaction proceeds the reaction product of the base and the hydrogen halide which is eliminated in the reaction separates out from the reaction mixture as a precipitate. Thus in the case of the use of alkali metal hydroxides, carbonates, or alkoxides as the base, the corresponding alkali metal halide will separate as a precipitate but may redissolve into the aqueous or alcoholic component. In the case of the use of a tertiary amine as the base, the corresponding hydrohalide of the tertiary amine will separate from solution. The completion of the reaction is signalled by the point at which no further precipitate separates from the reaction mixture. The resulting reaction mixture, after cooling if necessary, is then treated to isolate the desired component (a). A particularly convenient way of achieving this result is to pour the reaction mixture into a large excess of water. The desired product is thereby precipitated and the other components of the mixture pass into solution in the water. Hence the desired product can be isolated by filtration or like means. The product so isolated can be purified, if desired, by recrystallization, reprecipitation or like conventional means. In general it is found that such purification is unnecessary provided the product is washed well with water after isolation from the reaction mixture in the above manner.

The sulfonyl halide (I) employed in the above reaction can be either the 4- or 5-isomer and is preferably in the form of the sulfonyl chloride or bromide, the chloride being the preferred species.

The component (b) employed in the compositions of the invention can be any of the novolac resins conventionally employed in positive-acting photoresist compositions. A particularly preferred group of such resins for use in the present invention comprises those derived primarily from m-cresol or p-cresol alone or a mixture thereof. Advantageously, the resins employed in the compositions of the invention, including the preferred group, have average molecular weights in the range of about 800 to about 20,000 and preferably from about 4,000 to 8,000.

The light-sensitive resin component (a) and the non-light-sensitive novolac resin component (b) are employed in the compositions of the invention in admixture in a ratio by weight of (a) to (b) in the range of about 1:1 to about 1:10. Preferably the weight ratio of (a) to (b) is in the range of about 1:3 to about 1:5 and a most preferred ratio is 1:3.8 to 1:4.5. The proportion of the light-sensitive resin component (a) in these compositions is significantly lower than the proportion (at least 1:1) called for by the aforesaid U.S. Patent 4,141,733. The lower proportion employed in the present invention is possible because of the much higher proportion of the diazo sulfonyl substituents present in the component (a) as discussed above. It is believed that it is this combination of factors, i.e. higher substitution of diazo sulfonyl substituents in component (a) which, in turn, enables one to use a lower proportion of component (a) in admixture with component (b), which gives rise to the improved properties of the compositions of the invention.

The compositions of the invention generally also comprise a solvent or a mixture of solvents. The solvent or solvents employed is or are generally selected based on compatibility with the other components of the photoresist and like considerations. Illustrative of solvents employed alone or admixture in the compositions of the invention are ketones such as methylethylketone, methylisopropylketone, diethylketone, cyclopentanone, cyclohexanone and the like; chlorinated hydrocarbons such as trichloroethylene, 1,1,1-trichloroethane and the like; aliphatic alcohols such as ethanol, n-propyl alcohol, n-butyl alcohol, n-hexyl alcohol and the like; aliphatic esters such as n-butyl acetate, n-hexyl acetate, cellosolve acetate, ethyl lactate and the like; glycol ethers such as ethylene glycol monomethyl ether, propylene glycol monomethyl ether and esters thereof such as the acetates, propionates and the like; and aromatic hydrocarbons such as toluene, xylene and the like; and aromatic ethers such as anisole. A preferred group of solvents are the aliphatic alcohols, aliphatic esters, glycol ether esters and aromatic hydrocarbons and mixtures of two or more such solvents. In general, the amount of solvent ranges from about 35 percent to about 85 percent by weight of the total composition.

The amount of the combined components (a) and (b) present in the total composition including solvents is advantageously within the range of about 10 to about 50 percent by weight and, preferably, within the range of about 15 to about 35 percent by weight.

The compositions of the invention may also comprise other optional components conventionally employed in the art such as plasticizers, surfactants, adhesion-promoters, finely-divided pigments and the like.

The photoresist compositions of the invention can be employed to prepare positive resist images using procedures conventional in the art. Illustratively the compositions are applied as a film coating to a substrate using conventional techniques, the solvent is removed from the film and the film is exposed imagewise to a source of UV-radiation of a wavelength in the range of about 410 nm to about 280 nm in the case where component (a) is substituted by the 4-isomer of the diazo naphthaguinone sulfonyl moiety and about 450 to 300 nm in the case of the corresponding 5-isomer. The exposed portions of the film are thereby rendered soluble in alkali and a positive image is thereafter developed by dissolving out the exposed portions of the film using an alkaline developer. Illustrative of such developers are aqueous sodium or potassium hydroxide, sodium metasilicate, sodium orthophosphate, sodium hydrogen phosphate, tetramethylammonium hydroxide, choline, and the like.

It is found that the images so produced exhibit excellent contrast, high sub-micron resolution and substantially vertical sidewalls. Further, there is markedly less depletion of photoresist from the unexposed portions during the development of the image than has been encountered hitherto in the art. The development of the image exhibiting these highly advantageous properties can be carried out using any of the developers commonly employed in the art.

The following examples illustrate the process and compositions of the invention and show the best mode known to the inventors of carrying out the invention, but are not to be construed as limiting.

### Example 1

(a) A mixture of 3000 g. (27.8 mole) of p-cresol, 1600 g. (19.7 mole) of 37 w/w formaldehyde and 20 g. of oxalic acid was heated with stirring to 80°C. An exothermic reaction commenced and the temperature reached a high of 95°C. Stirring was continued until the temperature fell to ambient (circa 20°C.). The resulting mixture was allowed to stand overnight before being heated to 230°C. under reduced pressure (10 Torr) to remove water, unreacted p-cresol and lower molecular weight oligomers. The residual novolac resin (2654 g.) had a softening point of 99.5-100°C. and an average molecular weight determined by gel permeation chromatography of 600.
(b) To a solution of 180.3 g. (1.5 hydroxyl equivalents) of the novolac resin obtained as described above in 600 ml. of dioxane was added 160.9 g. (0.56 moles) of 94 percent pure 2-diazo-1,2-naphthoquinone 5-sulfonyl chloride. The resulting mixture was stirred and cooled while a total of 68.8 g. (0.59 moles) of diethylethanolamine was added dropwise at a rate such that the temperature of the reaction mixture did not exceed 25°C. When the addition was complete the mixture was stirred for a further 30 minutes before being poured with vigorous stirring into 5000 g. of water to which had been added 50 g. of concentrated hydrochloric acid. The precipitate so formed was isolated by filtration, washed thoroughly with water while on the filter and dried in a vacuum oven at 35°C. for 48 hours. There was thus obtained a light-sensitive novolac resin in accordance with the invention having an average of one 2-diazo-1,2-naphthoquinone-5-sulfonyl substituent per 2.7 hydroxyl groups in the starting novolac resin.

### Example 2

Using the procedure described in Example 1, parts (a) and (b), but replacing the 2-diazo-1,2-naphthoquinone-5-sulfonyl chloride employed in part (b) by an equal amount of 2-diazo-1,2-naphthoquinone-4-sulfonyl chloride, there is obtained a light-sensitive novolac resin in accordance with the invention.

### Example 3

A positive photoresist composition in accordance with the invention was prepared by admixing the following components in the proportions shown (all parts by weight):

| | |
|---|---|
| novolac resin ¹ : | 23.00 |
| light-sensitive resin of Example 1: | 6.00 |
| surfactant : | 0.05 |
| solvent ² : | 70.95 |

| | |
|---|---|
| Footnotes: 1: acid-catalysed formaldehyde/m-cresol/p-cresol condensate. | |
| 2: mixture of propylene glycol monomethylether acetate, xylene and butyl acetate. | |

An aliquot of the above composition was applied to a silicon wafer by spin-coating and the coated wafer was baked at 110°C. for 50 seconds. The average thickness of the resulting film was 1.8 microns. The film was then exposed via a photomask having submicron circuitry patterns to ultraviolet light in a broad band exposure mode (300-436 nm; 110 mJ/cm²). The exposed film was developed using an aqueous alkaline developer (MF-29 : MacDermid, Inc., Waterbury, CT) for 2 minutes at 21°C. The resist image so produced was scanned by electron microscopy and observed to have excellent contrast, high resolution and sidewalls which were substantially vertical (88-89° with respect to the substrate surface).

### Example 4

A positive photoresist composition in accordance with the invention was prepared as described in Example 3, but replacing the light-sensitive resin of Example 1 by an equal amount of the light-sensitive resin of Example 2, keeping all other components and proportions unchanged.

An aliquot of the above composition was applied to a silicon wafer by spin-coating and the coated wafer was baked at 110°C. for 50 seconds. The average thickness of the resulting film was 1.8 microns. The film was then exposed imagewise using an I-line exposure tool (250 mJ/cm²) and the image was developed using the same alkaline developer and conditions employed in Example 3. The resulting image was scanned by electron microscopy and found to comprise lines of width 0.6 microns with substantially vertical sidewalls (89-90° with respect to the substrate surface).

## Claims

1. A positive photoresist composition which comprises, in admixture:
(a) a light-sensitive novolac resin; and
(b) a non-light-sensitive novolac resin;
said component (a) comprising the product of reaction of a 2-diazo-1,2-naphthoquinone sulfonyl halide and a novolac obtained by the reaction of para cresol and formaldehyde and having an average molecular weight in the range of about 500 to about 1500 using a ratio of moles of halide per hydroxyl group in said resin in the range of about 1:1 to about 1:5;
the ratio by weight of component (a) to component (b) being within the range of about 1:1 to about 1:10.

2. A photoresist composition according to claim 1 wherein the 2-diazo-1,2-naphthoquinone sulfonyl halide is 2-diazo-1,2-naphthoquinone-4-sulfonyl chloride.

3. A photoresist composition according to claim 1 wherein the 2-diazo-1,2-naphthoquinone sulfonyl halide is 2-diazo-1,2-naphthoquinone-5-sulfonyl chloride.

4. A photoresist composition according to any one of claims 1 to 3 wherein said novolac resin has an average molecular weight in the range of about 700 to 1000.

5. A photoresist composition according to any one of the preceding claims wherein the ratio of moles of 2-diazo-1,2-naphthoquinone sulfonyl halide per hydroxyl group in the novolac resin is in the range of about 1:2 to about 1:4.

6. A photoresist composition according to any one of the preceding claims wherein the reaction between said sulfonyl halide and said novolac is carried out in the presence of a base.

7. A photoresist composition according to any one of the preceding claims which also comprises a solvent.

8. A photoresist composition according to claim 7 wherein said solvent comprises a mixture of propylene glycol methyl ether acetate, xylene and butyl acetate.

9. A photoresist composition according to any one of the preceding claims wherein the combined amount of components (a) and (b) in said composition is about 10 to about 50 percent by weight.

10. A photoresist composition according to any one of the preceding claims wherein the ratio by weight of component (a) to component (b) is in the range of about 1:3 to about 1:5.

11. A method of preparing a positive photoresist image on a substrate which comprises applying to said substrate a coating of a composition as claimed in any one of the preceding claims, exposing the coating imagewise to ultraviolet radiation and developing the positive image using an alkaline developer.

## Patentansprüche

1. Positive Photoresistzusammensetzung, die im Gemisch umfaßt:
(a) ein lichtempfindliches Novolakharz; und
(b) ein nicht-lichtempfindliches Novolakharz;
worin Komponente (a) das Reaktionsprodukt eines 2-Diazo-1,2-naphthochinonsulfonylhalogenids und eines durch die Reaktion von para-Kresol und Formaldehyd erhaltenen Novolaks umfaßt und ein durchschnittliches Molekulargewicht im Bereich von etwa 500 bis etwa 1500 aufweist, wobei ein Molverhältnis von Halogenid pro Hydroxylgruppe in dem Harz im Bereich von etwa 1 : 1 bis etwa 1 : 5 verwendet wird;
worin das Gewichtsverhältnis von Komponente (a) zu Komponente (b) im Bereich von etwa 1 : 1 bis etwa 1 : 10 liegt.

2. Photoresistzusammensetzung nach Anspruch 1, worin das 2-Diazo-1,2-naphthochinonsulfonylhalogenid 2-Diazo-1,2-naphthochinon-4-sulfonylchlorid ist.

3. Photoresistzusammensetzung nach Anspruch 1, worin das 2-Diazo-1,2-naphthochinonsulfonylhalogenid 2-Diazo-1,2-naphthochinon-5-sulfonylchlorid ist.

4. Photoresistzusammensetzung nach einem der Ansprüche 1 bis 3, worin das Novolakharz ein durchschnittliches Molekulargewicht im Bereich von etwa 700 bis 1000 aufweist.

5. Photoresistzusammensetzung nach einem der vorstehenden Ansprüche, worin das Molverhältnis von 2-Diazo-1,2-naphthochinonsulfonylhalogenid pro Hydroxylgruppe in dem Novolakharz im Bereich von etwa 1 : 2 bis etwa 1 : 4 liegt.

6. Photoresistzusammensetzung nach einem der vorstehenden Ansprüche, worin die Reaktion zwischen dem Sulfonylhalogenid und dem Novolak in Gegenwart einer Base durchgeführt wird.

7. Photoresistzusammensetzung nach einem der vorstehenden Ansprüche, die auch ein Lösungsmittel enthält.

8. Photoresistzusammensetzung nach Anspruch 7, worin das Lösungsmittel ein Gemisch aus Propylenglykolmethyletheracetat, Xylol und Butylacetat umfaßt.

9. Photoresistzusammensetzung nach einem der vorstehenden Ansprüche, worin die kombinierte Menge der Komponenten (a) und (b) in der Zusammensetzung etwa 10 bis etwa 50 Gew.-% beträgt.

10. Photoresistzusammensetzung nach einem der vorstehenden Ansprüche, worin das Gewichtsverhältnis von Komponente (a) zu Komponente (b) im Bereich von etwa 1 : 3 bis etwa 1 : 5 liegt.

11. Verfahren zur Herstellung eines positiven Photoresistbildes auf einem Substrat, das das Aufbringen einer Beschichtung aus einer Zusammensetzung nach einem der vorstehenden Ansprüche auf das Substrat, bildweises Belichten der Beschichtung mit ultravioletter Strahlung und Entwickeln des positiven Bildes unter Verwendung eines alkalischen Entwicklungsmittels umfaßt.

## Revendications

1. Composition de photorésist positive qui comprend, en mélange :
(a) une résine novolaque sensible à la lumière ; et
(b) une résine novolaque non sensible à la lumière ;
ce constituant (a) comprenant le produit de la réaction d'un halogénure de 2-diazo-1,2-naphtoquinone-sulfonyle et d'une résine novolaque obtenue par réaction du paracrésol et du formaldéhyde et ayant une masse moléculaire moyenne dans l'intervalle d'environ 500 à environ 1500 en utilisant un rapport molaire de l'halogénure par groupe hydroxyle de cette résine dans l'intervalle d'environ 1:1 à environ 1:5 ;
le rapport pondéral du constituant (a) au constituant (b) étant dans l'intervalle d'environ 1:1 à environ 1:10.

2. Composition de photorésist selon la revendication 1, dans laquelle l'halogénure de 2-diazo-1,2-naphtoquinone-sulfonyle est le chlorure de 2-diazo-1,2-naphtoquinone-4-sulfonyle.

3. Composition de photorésist selon la revendication 1, dans laquelle l'halogénure de 2-diazo-1,2-naphtoquinone-sulfonyle est le chlorure de 2-diazo-1,2-naphtoquinone-5-sulfonyle.

4. Composition de photorésist selon l'une quelconque des revendications 1 à 3, dans laquelle cette résine novolaque a une masse moléculaire moyenne dans l'intervalle d'environ 700 à 1000.

5. Composition de photorésist selon l'une quelconque des revendications précédentes, dans laquelle le rapport molaire de l'halogénure de 2-diazo-1,2-naphtoquinone-sulfonyle par groupe hydroxyle de la résine novolaque est dans l'intervalle d'environ 1:2 à environ 1:4.

6. Composition de photorésist selon l'une quelconque des revendications précédentes, dans laquelle la réaction entre cet halogénure de sulfonyle et cette novolaque est effectuée en présence d'une base.

7. Composition de photorésist selon l'une quelconque des revendications précédentes, qui comprend également un solvant.

8. Composition de photorésist selon la revendication 7, dans laquelle ce solvant comprend un mélange d'acétate de l'éther méthylique du propylèneglycol, de xylène et d'acétate de butyle.

9. Composition de photorésist selon l'une quelconque des revendications précédentes, dans laquelle la quantité combinée des constituants (a) et (b) de cette composition est d'environ 10 à environ 50 % en poids.

10. Composition de photorésist selon l'une quelconque des revendications précédentes, dans laquelle le rapport pondéral du constituant (a) au constituant (b) est dans l'intervalle d'environ 1:3 à environ 1:5.

11. Procédé de préparation d'une image de photorésist positive sur un substrat qui comprend le fait d'appliquer sur ce substrat un revêtement d'une composition telle que revendiquée dans l'une quelconque des revendications précédentes, d'exposer le revêtement conformément à une image à un rayonnement ultraviolet et de développer l'image positive en utilisant un révélateur alcalin.
